# EUROPÄISCHE PATENTANMELDUNG

(11) **EP 3 787 046 A1**
(43) Veröffentlichungstag der Anmeldung: **03.03.2021**
(21) Anmeldenummer: 20000296.2
(22) Anmeldetag: 18.08.2020
(51) Int. Cl.: H01L 31/0687, H01L 31/0224, H01L 31/0216

(54) **STAPELFÖRMIGE MEHRFACHSOLARZELLE MIT EINEM DIELEKTRISCHEN ISOLATIONSSCHICHTSYSTEM**

(30) Priorität: 29.08.2019 DE 102019006096
(71) Anmelder: AZUR SPACE Solar Power GmbH, 74072 Heilbronn (DE)
(72) Erfinder: Kubera, Tim, 74211 Leingarten (DE); Fuhrmann, Bianca, 74081 Heilbronn (DE)
(74) Vertreter: Koch Müller Patentanwaltsgesellschaft mbH

(57) **Zusammenfassung**

Stapelförmige Mehrfachsolarzelle mit einem dielektrischen Isolationsschichtsystem, wobei die Mehrfachsolarzelle ein eine Unterseite der Mehrfachsolarzelle ausbildendes Germanium-Substrat, eine Germanium-Teilzelle und mindestens zwei III-V-Teilzellen in der genannten Reihenfolge aufeinander folgend aufweist, das Isolationsschichtsystem eine Schichtfolge aus mindestens einer stoffschlüssig mit einem ersten Oberflächenabschnitt der Mehrfachsolarzelle verbundenen untersten Isolationsschicht und einer eine Oberseite des Isolationsschichtsystems ausbildenden obersten Isolationsschicht aufweist, und eine Metallisierung der Mehrfachsolarzelle mit einem an den ersten Oberflächenabschnitt der Mehrfachsolarzelle angrenzenden zweiten Oberflächenabschnitt stoffschlüssig und elektrisch leitfähig verbunden ist und mit einem Abschnitt der Oberseite des Isolationsschichtsystems stoffschlüssig verbunden ist und die oberste Isolationsschicht a-Silizium umfasst oder aus a-Silizium besteht.

## Beschreibung

Die Erfindung betrifft eine stapelförmige Mehrfachsolarzelle mit einem dielektrischen Isolationsschichtsystem.

Es sind unterschiedliche Verfahren zur Passivierung und Metallisierung von Halbleiterscheiben bekannt. Die gewünschte Metallstruktur wird beispielsweise mit Hilfe einer Lackmaske aus Positivlack oder aus Negativlack auf einer Isolationsschicht erzeugt, wobei das Metall flächig, z.B. mittels physikalischer Gasphasenabscheidung, aufgebracht wird.

Alternativ werden Druckverfahren genutzt, z.B. Siebdruck oder Dispensköpfe, welche direkt nur die gewünschte Metallstruktur aufbringen.

Um die Abschattung der Vorderseite einer Solarzelle zu reduzieren, ist es möglich, die Vorderseite mittels einer Durchgangskontaktöffnung von der Rückseite zu kontaktieren. Solche Solarzellen werden auch als metal wrap through (MWT) - Solarzellen bezeichnet.

Neben unterschiedlichen Herstellungsverfahren der Durchgangskontaktöffnung sind auch unterschiedliche Metallisierungsverfahren bekannt, um insbesondere eine zuverlässige Isolierung und Metallisierung im Bereich der Durchgangskontaktöffnung zu erreichen.

Aus der US 2013/0220396 A1 Ist eine MWT-Solarzelle auf Siliziumbasis bekannt. Aus der US 2014/0174518 A1 ist eine ebenfalls Silizium-basierte Solarzellenstruktur mit einer verbesserten Passivierungsschichtfolge bekannt.

Aus "III-V multi-junction metal-wrap-through (MWT) concentrator solar cells", E. Oliva et al., Proceedings, 32nd European PV Solar Energy Conference and Exhibition, München, 2016, pp. 1367-1371, ist eine invertiert gewachsene GaInP/AIGaAs Solarzellenstruktur mit Durchgangskontaktöffnungen bekannt, wobei die Solarzellenstruktur mit den pn-Übergängen epitaktisch gewachsen und erst anschließend die Durchgangskontaktöffnung mittels Trockenätzen erzeugt wird. Die Seitenfläche der Durchgangsöffnung wird dann mit einer Isolationsschicht beschichtet und die Durchgangskontaktöffnung wird anschließend galvanisch mit Kupfer gefüllt.

Aus der US 9,680,035 B1 ist ein Solarzellenstapel aus mehreren III-V-Teilzellen auf einem GaAs-Substrat mit rückseitenkontaktierter Vorderseite bekannt, wobei ein von der Oberseite der Solarzelle durch die Teilzellen bis in eine noch nicht gedünnte Substratschicht hineinreichendes Loch mittels eines nasschemischen Ätzprozesses erzeugt wird und erst durch Dünnen der Substratschicht nach unten geöffnet wird.

Vor dem Dünnen werden metallische Kontaktflächen auf der Solarzellenstapeloberseite angeordnet, die sich anschließende Oberseite sowie die Seitenfläche des Lochs mit einer Isolationsschicht beschichtet und anschließend eine Metallschicht auf die metallischen Kontaktflächen und die Isolationsschicht aufgebracht.

Für eine gute Haftung einer Metallschicht auf einem Dielektrikum, z.B. auf Siliziumdioxid oder auf Siliziumnitrid, wird typischer Weise Titan eingesetzt. Eine zuverlässige und langlebige Haftung auf Halbleiterschichten aus Germanium oder III-V-Halbleitern wird dagegen beispielsweise mit Silber, Palladium oder Gold-Germanium erreicht.

Vor diesem Hintergrund besteht die Aufgabe der Erfindung darin, eine Vorrichtung anzugeben, die den Stand der Technik weiterbildet.

Die Aufgabe wird durch eine stapelförmige Mehrfachsolarzelle mit den Merkmalen des Patentanspruchs 1 gelöst. Vorteilhafte Ausgestaltungen der Erfindung sind Gegenstand von Unteransprüchen.

In dem Gegenstand der Erfindung wird eine stapelförmige Mehrfachsolarzelle mit einem dielektrischen Isolationsschichtsystem bereitgestellt, wobei die Mehrfachsolarzelle ein eine Unterseite der Mehrfachsolarzelle ausbildendes Germanium-Substrat, eine Germanium-Teilzelle und mindestens zwei III-V-Teilzellen in der genannten Reihenfolge aufeinander folgend aufweist.

Das Isolationsschichtsystem weist eine Schichtfolge aus mindestens einer stoffschlüssig mit einem ersten Oberflächenabschnitt der Mehrfachsolarzelle verbundenen untersten Isolationsschicht und einer eine Oberseite des Isolationsschichtsystems ausbildenden obersten Isolationsschicht auf.

Eine Metallisierung der Mehrfachsolarzelle ist mit einem an den ersten Oberflächenabschnitt der Mehrfachsolarzelle angrenzenden zweiten Oberflächenabschnitt stoffschlüssig und elektrisch leitfähig verbunden.

Außerdem ist die Metallisierung mit einem Abschnitt der Oberseite des Isolationsschichtsystems stoffschlüssig verbunden.

Die oberste Isolationsschicht umfasst amorphes Silizium oder besteht aus amorphem Silizium.

Es versteht sich dass der erste Oberflächenabschnitt und der zweite Oberflächenabschnitt auf der Oberseite der Mehrfachsolarzelle oder auf der Unterseite der Mehrfachsolarzelle ausgebildet sind.

Es sei angemerkt, dass der erste Oberflächenabschnitt überwiegend oder vollständig mit einer dielektrischen Schicht umfassend vorzugsweise wenigstens eine Siliziumdioxidschicht bedeckt ist. Der zweite Oberflächenabschnitt ist überwiegend oder vollständig mit einem III-V Material bedeckt.

Entsprechend werden die Oberflächenabschnitte entweder von dem Ge-Substrat oder von einer die Oberseite der Halbleiterscheibe ausbildenden Schicht, z.B. eine III-V-Teilzelle oder einer III-V-Capschicht, d.h. Abdeckschicht ausgebildet. Es versteht sich hierbei, dass im Unterschied zu Metallisierungen von Silizium eine völlig andere Technologie verwendet werden muss, um eine möglichst haltbare und möglichst niederohmige Verbindung zu erzielen.

Außerdem versteht es sich, dass eine Ge-Teilzelle Germanium aufweist oder aus Germanium besteht, wobei auch eine aus Germanium bestehende Schicht gegebenenfalls zusätzlich zu dem Germanium noch weitere Stoffe, insbesondere Dotierstoffe, aber auch Verunreinigungen enthält.

Entsprechendes gilt auch für die III-V-Teilzellen, welche ein oder mehrere Materialien der III. sowie der V. Hauptgruppe aufweisen oder aus solchen Materialien bestehen.

Die a-Silizium-Schicht stellt eine zuverlässige und langlebige Haftung mit vielen unterschiedlichen Metallisierungen sicher. Hierdurch ist es insbesondere möglich, einen Stoffschluss zwischen einer typischen Metallisierung für Halbleiteroberflächen, wie insbesondere Germanium, aber auch III-V-Halbleitermaterialien, und der dielektrischen Schicht zu erreichen.

Hierbei ist das gesamte Isolationsschichtsystem auf einfache Weise in einem einzigen Abscheideprozess, z.B. plasmaunterstützte chemische Gasphasenabscheidung oder APCVD oder Atomlagenabscheidung, erzeugbar.

Ein Vorteil ist, dass das Isolationsschichtsystem somit keine weiteren Prozessschritte erfordert und andererseits viele Möglichkeiten zur Optimierung des Herstellungsprozesses sowie hinsichtlich der Ausgestaltung der Metallisierung eröffnet, vorzugsweise im Hinblick auf Durchgangskontaktierungen.

Insbesondere lassen sich Prozessschritte, zusätzliche bzw. unterschiedliche Metallstrukturen einsparen. Hierdurch stellt die Mehrfachsolarzelle eine besonders kostengünstige und effiziente Lösung dar.

Ein weiterer Vorteil ist, dass bei einer III- V Solarzellenstapel mit einen Ge-Substrat die Metallisierung sowohl auf einer Oberfläche der Isolationsschicht als auch auf einer Oberfläche der III-V Solarzelle und / oder auf der Oberfläche des Ge-Substrats ausgebildet ist.

Die Metallschicht muss folglich zuverlässig und reproduzierbar ein Stoffschluss sowohl zu der Isolationsschicht als auch zu der Germanium- oder zu der III-V-Oberfläche ausbilden und ebenso zuverlässig einen ohmschen Kontakt zu der Germanium- und / oder zu der III-V-Oberfläche herstellen.

In einer ersten Ausführungsform umfasst die unterste Isolationsschicht SiO₂ und/oder Si₃N₄ oder besteht aus SiO₂ und/oder Si₃N₄.

In einer anderen Ausführungsform weist das Isolationsschichtsystem mindestens eine weitere mittlere Isolationsschicht auf, wobei die mindestens eine mittlere Isolationsschicht SiO₂ und/oder Si₃N₄ umfasst oder aus SiO₂ und/oder Si₃N₄ besteht. Hierbei versteht es sich, dass die unterste Isolationsschicht ein anderes Material aufweist als die mittlere Isolationsschicht.

In einer weiteren Ausführungsform weist die Mehrfachsolarzelle eine rückseitenkontaktierte Vorderseite auf, wobei die Halbleiterscheibe mindestens ein von einer Oberseite der Mehrfachsolarzelle durch die Teilzellen bis zu der Unterseite reichendes Durchgangskontaktloch mit zusammenhängender Seitenwand und einem im Querschnitt parallel zur Oberfläche ovalen Umfang aufweist und eine Seitenwand des Durchgangskontaktlochs von dem dielektrischen Isolationsschichtsystem bedeckt ist.

In einer Weiterbildung erstreckt sich die Metallisierung auf dem Isolationsschichtsystem von der Oberseite der Mehrfachsolarzelle entlang der Seitenwand durch das Durchgangskontaktloch bis zu der Unterseite der Mehrfachsolarzelle.

In einer anderen Ausführungsform umfasst die Metallisierung ein Mehrschichtsystem. In einer Weiterbildung umfasst das Mehrschichtsystem eine AuGe/Ti/Pd/Ag/Au-Schichtfolge oder eine Pd/Au/Ge/Ti/Pd/Ag/Au-Schichtfolge umfasst. Insbesondere die AuGe/Ti/Pd/Ag/Au-Schichtfolge ist eine weit verbreitete und bewährte Schichtfolge, um eine Metallisierung auf Germanium-Schichten zu erreichen.

Für Konzentratorsolarzellen (CPV) hat sich insbesondere die Pd/Au/Ge/Ti/Pd/Ag/Au-Schichtfolge bewährt. Da das Pd im Vergleich zu Ti eine höhere Reflektivität bzw. Leitfähigkeit im Wellenlängenbereich 1 µm bis 3 µm besitzt, ergibt sich ein weiterer Vorteil für die Solarzellen aufgrund des sogenannten 'Rückseiten-Reflektors'.

In einer alternativen Weiterbildung weist das Mehrschichtsystem als unterste Schicht eine Nickel umfassende Schicht oder eine Aluminium umfassende Schicht auf.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: einen Ausschnitt einer ersten Ausführungsform einer Mehrfachsolarzelle mit dielektrischem Isolationsschichtsystem,
- Figur 2: eine weitere Ausführungsform einer Mehrfachsolarzelle mit dielektrischem Isolationssystem,
- Figur 3: eine weitere Ausführungsform einer Mehrfachsolarzelle mit dielektrischem Isolationssystem,
- Figur 4: eine Rückseitenansicht der Mehrfachsolarzelle in einer weiteren Ausführungsform.

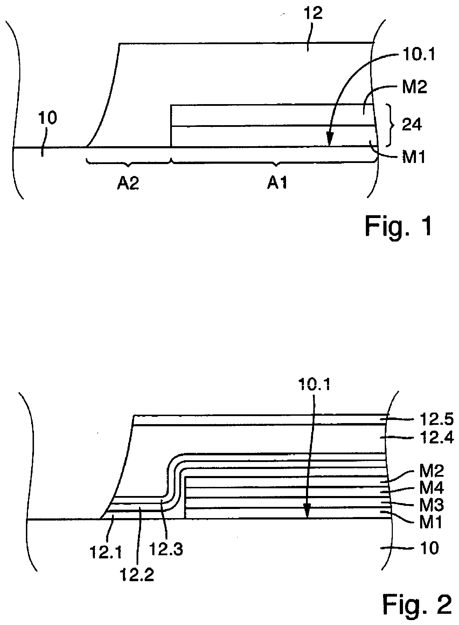

Die Abbildung der Figur 1 zeigt einen Ausschnitt einer Oberfläche einer stapelförmigen Mehrfachsolarzelle 10. Die Oberfläche wird durch eine Halbleiterschicht, z.B. eine Germanium oder einen III-V-Halbleiter umfassende Schicht ausgebildet. Auf einem ersten Oberflächenabschnitt A1 der Oberseite 10.1 ist ein dielektrisches Isolationsschichtsystem 24 aus einer untersten Isolationsschicht M1 und einer obersten Isolationsschicht M2.

Die unterste Isolationsschicht M1 ist stoffschlüssig mit der Oberseite 10.1 der Mehrfachsolarzelle 10 verbunden. Die unterste Isolationsschicht umfasst SiO₂ und/oder Si₃N₄ oder besteht aus SiO₂ und/oder Si₃N₄.

Eine Oberseite des Isolationsschichtsystems 24 wird von der obersten Isolationsschicht M2 ausgebildet, wobei die oberste Isolationsschicht M2 aus α-Silizium besteht.

Auf einem sich an den ersten Oberflächenabschnitt A1 anschließenden zweiten Oberflächenabschnitt A2 sowie auf der Oberseite des Isolationsschichtsystems 24 ist eine Metallisierung 12 ausgebildet. Die Metallisierung ist mit der Oberseite 10.1 der Mehrfachsolarzelle 10 stoffschlüssig und elektrisch leitfähig verbunden. Außerdem ist die Metallisierung 12 mit der Oberseite des Isolationsschichtsystems 24, also mit der α-Silizium-Schicht M2 stoffschlüssig verbunden.

In der Abbildung der Figur 2 ist eine weitere Ausführungsform dargestellt. Im Folgenden werden nur die Unterschiede zu der Abbildung der Figur 1 erläutert. Die weitere Ausführungsform umfasst als Ausschnitt einen Teil des Oberflächenabschnitts A1 und einen Teil des Oberflächenabschnitts A2.

In dem ersten Oberflächenabschnitt A1 umfasst die dielektrische Schichtfolge 24 zwischen der untersten Isolationsschicht M1 und der obersten Isolationsschicht M2 zwei mittlere Isolationsschichten M3 und M4.

Die beiden mittleren Isolationsschicht M3 und M4 umfassen jeweils SiO₂ und/oder Si3N4 oder bestehen jeweils aus SiO₂ und/oder Si3N4. Hierbei weist die untere Isolationsschicht M1 ein anderes Material als wenigstens eine der beiden mittleren Isolationsschichten M3 und M4 auf.

In dem Ausschnitt in dem Bereich des Oberflächenabschnitts A1 ist auf der dielektrischen Schichtfolge 24 zur Metallisierung 12 ein Schichtsystem als eine Abfolge von fünf Metallschichten 12.1, 12.2, 12.3, 12.4 und 12.5 als eine AuGe/Ti/Pd/Ag/Au-Schichtfolge oder als eine Pd/Au/Ge/Ti/Pd/Ag /Au-Schichtfolge ausgebildet, wobei als erste Metallschicht 12.1 des Schichtsystems d.h. die AuGe Schicht oder die Pd Schicht stoffschlüssig mit der Oberfläche der obersten Isolationsschicht M2 des darunterliegenden Isolationsschichtsystems 24 verbunden ist. Des Weiteren ist in dem Bereich des Oberflächenabschnitts A2 die erste Metallschicht 12.1 stoffschlüssig mit der elektrisch leitfähigen Halbleiteroberfläche der Mehrfachsolarzelle verbunden.

Anders ausgedrückt, die Abfolgen der fünf Metallschichten 12.1, 12.2, 12.3, 12.4, und 12.5 überdecken in dem dargestellten Ausschnitt an der Oberseite 10.1 die Oberseite des Isolationsschichtsystems 24, d.h. die Oberfläche der oberen Isolationsschicht M2.

Des Weiteren überdeckt die Metallisierung 12 in dem dargestellten Abschnitt als Teil des Oberflächenabschnitts A2 die Oberfläche der Mehrfachsolarzelle.

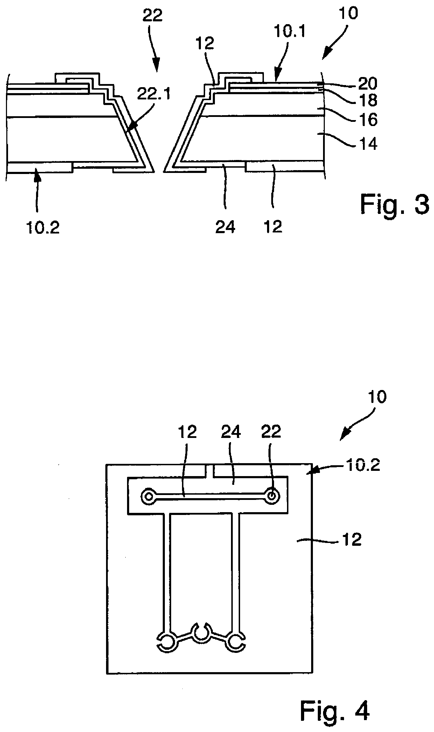

In der Abbildung der Figur 3 ist ein Querschnitt durch eine Öffnung dargestellt. Im Folgenden werden nur die Unterschiede zu der Abbildung der Figur 1 oder zu der Figur 2 erläutert.

Die stapelförmige Mehrfachsolarzelle 10 weist eine Öffnung 22 mit einer Seitenwand 22.1 auf. Auf dem Ge-Substrat 14, das selbst vorzugsweise ebenfalls als Teilzelle ausgebildet ist, sind mehrere III-V Teilzellen 16, 18, und 20 ausgebildet.

Das Isolationsschichtsystem 24 erstreckt sich von dem ersten Oberflächenabschnitt A1 über den zweiten Oberflächenabschnitt A2 auf der Oberseite 10.1 durch die Öffnung 22 hindurch zur Unterseite 10.2. Die Öffnung weist an der Oberseite 10.1 einen größeren Durchmesser auf als den der Unterseite 10.1. Anders ausgedrückt ist die Öffnung konisch ausgebildet.

Hierbei überdeckt das Isolationsschichtsystem 24 die Seitenwand 22.1 in der Öffnung rundherum vollständig, um zu verhindern, dass die Metallisierung in der Öffnung 22 die einzelnen Teilzellen 14, 16, 18 und 20 kurzschließt.

Die Metallisierung 12 ist stoffschlüssig mit der Vorderseite 10.1 der Mehrfachsolarzelle 10 elektrisch leitend verbunden und überdeckt anschließend das auf der Vorderseite 10.1 angeordnete Isolationsschichtsystem 24 und die Seitenflächen 22.1 der Öffnung vollständig sowie auf der Unterseite 10.2 ein Teil des Isolationsschichtsystems 24 um auf der Unterseite 10.2 eine Rückseitenkontaktfläche auszubilden. Hierdurch lässt sich die Vorderseite mittels der Rückseitenkontaktfläche elektrisch von der Rückseite bzw. von der Unterseite 10.2 anschließen.

Auf der Unterseite 10.2 ist durch ein Bereich des Isolationsschichtsystems 24 beabstandet elektrisch leitende Halbleiterrückseite d.h. die Rückseite des Ge-Substrat 12 ebenfalls von der Metallisierung 12 bedeckt. Infolge sind beide Kontakte der Mehrfachsolarzelle von der Unterseite 10.2 anschließbar.

In der Abbildung der Figur 4 ist eine Draufsicht auf die Unterseite 10.2 der Ausführungsform, dargestellt in Zusammenhang mit der Abbildung 3, abgebildet. Im Folgenden werden nur die Unterschiede zu der Abbildung der Figur 3 erläutert.

Die Unterseite 10.2 der Mehrfachsolarzelle 10 überwiegend, d.h. zu mehr als 70 % von der Metallisierung 12 bedeckt, um die Rückseite der Mehrfachsolarzelle 10 elektrisch niederohmig anzuschließen.

Die Vorderseite 10.1 ist mit zwei Durchkontaktierungen, d.h. mittels zwei Öffnungen 22 von der Rückseite angeschlossen. Hierbei sind die beiden Bereiche um die Öffnungen 22, die als Rückseitenkontakt für die Vorderseite 10.1 ausgebildet sind, elektrisch mittels einer Leiterbahn verschaltet.

Aus Gründen der Isolation ist der Rückseitenkontaktbereich durch einen Isolationsbereich von dem Bereich der Metallisierung 12, die die Rückseite der Mehrfachsolarzelle 10 elektrisch anschließt, getrennt.

## Patentansprüche

1. Stapelförmige Mehrfachsolarzelle (10) mit einem dielektrischen Isolationsschichtsystem (24), wobei
- die Mehrfachsolarzelle (10) ein eine Unterseite (10.2) der Mehrfachsolarzelle (10) ausbildendes Germanium-Substrat (14), eine Germanium-Teilzelle (16) und mindestens zwei III-V-Teilzellen (18, 20) in der genannten Reihenfolge aufeinander folgend aufweist,
- eine Oberseite der Mehrfachsolarzelle (10) von einer der III-V-Teilzellen oder einer III-V-Capschicht ausgebildet wird,
- das Isolationsschichtsystem (24) eine Schichtfolge aus mindestens einer stoffschlüssig mit einem ersten Oberflächenabschnitt der Mehrfachsolarzelle (10) verbundenen untersten Isolationsschicht (M1) und einer eine Oberseite des Isolationsschichtsystems (24) ausbildenden obersten Isolationsschicht (M2) aufweist und
- eine Metallisierung (12) der Mehrfachsolarzelle (10) mit einem an den ersten Oberflächenabschnitt der Mehrfachsolarzelle (10) angrenzenden zweiten Oberflächenabschnitt der Mehrfachsolarzelle (10) stoffschlüssig und elektrisch leitfähig verbunden ist und mit einem Abschnitt der Oberseite des Isolationsschichtsystems (24) stoffschlüssig verbunden ist, wobei
- die oberste Isolationsschicht (M2) amorphes Silizium umfasst oder aus amorphem-Silizium besteht und
- der erste Oberflächenabschnitt (A1) und der zweite Oberflächenabschnitt (A2) auf der Oberseite der Mehrfachsolarzelle (10) oder auf der Unterseite der Mehrfachsolarzelle (10) ausgebildet sind.

2. Stapelförmige Mehrfachsolarzelle (10) nach Anspruch 1, **dadurch gekennzeichnet, dass** die unterste Isolationsschicht (24) SiO₂ und/oder Si₃N₄ umfasst oder aus SiO₂ und/oder Si₃N₄ besteht.

3. Stapelförmige Mehrfachsolarzelle (10) nach Anspruch 1 oder 2, **dadurch gekennzeichnet, dass** das Isolationsschichtsystem (24) mindestens eine weitere mittlere Isolationsschicht (M3, M4) aufweist, wobei die mindestens eine mittlere Isolationsschicht (M3, M4) SiO₂ und/oder Si₃N₄ umfasst oder aus SiO₂ und/oder Si₃N₄ besteht.

4. Stapelförmige Mehrfachsolarzelle (10) nach einem der vorstehenden Ansprüche, **dadurch gekennzeichnet, dass** die Mehrfachsolarzelle (10) eine rückseitenkontaktierter Vorderseite aufweist, wobei
- die Halbleiterscheibe mindestens ein von einer Oberseite (10.1) der Mehrfachsolarzelle (10) durch die Teilzellen (16, 18, 20) bis zu der Unterseite (10.2) reichendes Durchgangskontaktloch (22) mit zusammenhängender Seitenwand (22.1) und einem im Querschnitt parallel zur Oberfläche ovalen Umfang aufweist und
- eine Seitenwand (22.1) des Durchgangskontaktlochs (22) von dem dielektrischen Isolatlonsschichtsystem (24) bedeckt ist.

5. Stapelförmige Mehrfachsolarzelle (10) nach Anspruch 4, **dadurch gekennzeichnet, dass** sich die Metallisierung (12) auf dem Isolationsschichtsystem (24) von der Oberseite (10.1) der Mehrfachsolarzelle (10) entlang der Seitenwand (22.1) durch das Durchgangskontaktloch (22) bis zu der Unterseite (10.2) der Mehrfachsolarzelle (10) erstreckt.

6. Stapelförmige Mehrfachsolarzelle (10) nach einem der vorstehenden Ansprüche, **dadurch gekennzeichnet, dass** die Metallisierung ein Mehrschichtsystem (12) umfasst.

7. Stapelförmige Mehrfachsolarzelle (10) nach Anspruch 6, **dadurch gekennzeichnet, dass** das Mehrschichtsystem eine AuGe/Ti/Pd/Ag/Au-Schichtfolge oder eine Pd/Au/Ge/Ti/Pd/Ag/Au-Schichtfolge umfasst.

8. Stapelförmige Mehrfachsolarzelle (10) nach Anspruch 6, **dadurch gekennzeichnet, dass** das Mehrschichtsystem als unterste Schicht eine Nickel umfassende Schicht oder eine Aluminium umfassende Schicht aufweist.
